# EUROPEAN PATENT SPECIFICATION

(11) **EP 1 282 350 B1**
(45) Date of publication and mention of the grant of the patent: **26.04.2006**
(21) Application number: 01117537.9
(22) Date of filing: 20.07.2001
(51) Int. Cl.: H05K 13/04

(54) **Electronic component mounting apparatus**
Einrichtung zur Montage elektronischer Bauteile
Machine à monter des composants électroniques

(43) Date of publication of application: 05.02.2003
(73) Proprietor: Hitachi High-Tech Instruments Co., Ltd., Ora-gun, Gunma, 370-0596 (JP)
(72) Inventor: Yoshii,Takashi, Ora-gun, Gunma-ken (JP); Fukushima,Hideaki, Ora-gun, Gunma-ken (JP); Kawai,Akihiro, Ota-shi, Gunma-ken (JP)
(74) Representative: Glawe, Delfs, Moll

(56) References cited:
- EP-A- 0 395 002
- EP-A- 0 835 050
- EP-A- 0 895 450
- EP-A- 0 904 678
- EP-A- 1 018 862
- EP-A- 1 032 251
- US-A- 4 312 109
- US-A- 5 224 262
- US-A- 6 094 808

## Description

### Field of the invention

The present invention relates to an electronic component mounting apparatus that mounts an electronic component to a print board after a recognition processing unit performs recognition processing based on the result of the imaging of the electronic component performed by a recognition camera.

### Background of the invention

Such electronic component mounting apparatus was disclosed in Japanese laid open patent publication Hei 8-78893 (JP 807 8893). As to the component with lead such as connector, prior art usually performs the positioning of the component by performing the recognition processing of lead (electrode, ball) or molding only. In this case, the pre-registered information on lead and molding is all used for the recognition processing, and the position and the angle of the electronic component are calculated based on the result of the recognition processing. Document EP 0 895 450 A2 discloses also positioning correction after recognition processing.

However, when the position of the component with lead such as connector is determined based only on the position recognition of the tip of lead, an accurate angle relative to molding could not be obtained due to the poor accuracy of the electronic component itself.
Thus, in some cases, the pins and extrusion extruded from the molding are not accurately engaged with the holes formed in a print board.

### Summary of the invention

Therefore, the objective of the present invention is to accurately mount components with pins and extrusions extruded from the molding, such as connectors, such that the pins and extrusions are accurately engaged with the holes formed in a print board.

The invention provides an electronic component mounting apparatus having a recognition camera for imaging an electronic component and a recognition processing unit for performing recognition processing based on the results of the imaging, said electronic component being mounted on a print board, the apparatus comprising a memory which stores information regarding a use of the result of the recognition processing performed by the recognition processing unit and a control unit which realizes the information regarding the use of the result of the recognition processing, wherein the recognition processing performed by the recognition processing unit is performed on different locations of the electronic component and the information regarding the use of the result of the recognition processing is stored in the memory for each of the locations. The invention also provides a method for mounting an electronic component on a print board comprising the steps imaging of the electronic component; performing a recognition processing based on results of the imaging for a first and at least a second group of locations; realizing information regarding a use of the results of the recognition processing; and placing the electronic component.

In the present invention, said use is calculating the amount of positioning adjustment of said electronic component or dimensional inspection of lead bending.

### Brief Description of the Drawings

Fig. 1 is a plan view of an electronic component mounting apparatus.
Fig. 2 is a block diagram for controlling an electronic component mounting apparatus.
Fig. 3 shows a set of mounting data.
Fig. 4 shows a set of component positioning data.
Fig. 5 shows a set of component data.
Fig. 6 is a plan view of component P1.
Fig. 7 is a side view of component P1, being looked from the right.
Fig. 8 shows a set of component data of component P1.
Fig. 9 is a plan view of component Pn.
Fig. 10 is a side view of component Pn, being looked from the right.
Fig. 11 shows a set of component data of component Pn.

### Description of the Invention

An embodiment of the electronic component mounting apparatus based on the present invention will be described in detail referring to the drawings hereinafter.

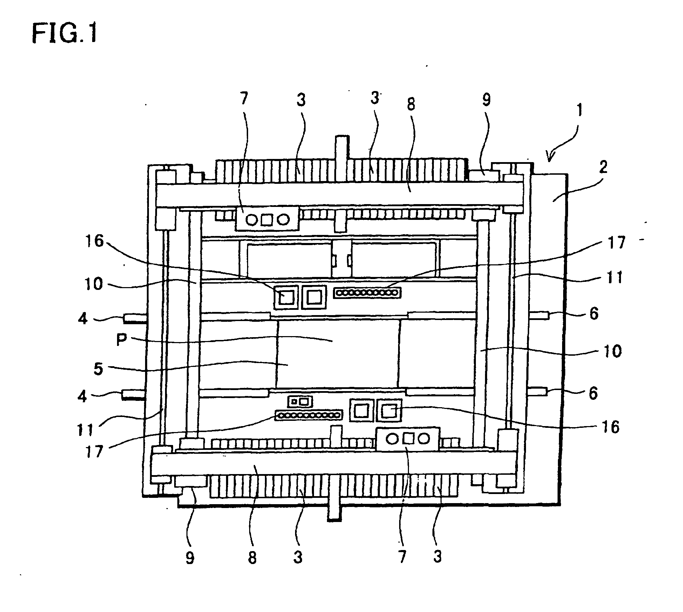

Fig. 1 is a plan view of an electronic component mounting apparatus 1. On a base 2 of said apparatus 1, a plurality of component feeding units 3 that feed one component of various kinds of electronic components at a time to each component pick-up portion (component suction position) is juxtaposed. Between the groups of the unit 3 facing each other, feeding conveyers 4, a positioning portion 5 and exhausting conveyers 6 are mounted. The feeding conveyer 4 receives the print board P from upper stream and sends the print board to said positioning portion 5. After an electronic component is mounted on said print board positioned by positioning mechanism, not shown in the figure, of said positioning portion 5, the print board is sent to the exhausting conveyer 6.

Reference numeral 8 is a pair of beams that extends in X direction, and moves the print board P or the upper part of the component pick-up portion (component suction position) of the feeding unit 3 individually in Y direction along with a pair of the parallel guides 11 by rotating the screw axis 10 by the drive of Y axis motor 9.

A mounting head 7 that moves in X direction, which is the longitudinal direction, along the guide (not shown in the figure) by the drive of an X axis motor 12 is mounted on each beam 8. On each mounting head 7, two vertical axis motors 14 that move two suction nozzles (not shown in the figure) in vertical direction and two θ axis motors for rotating the suction nozzles around vertical axis are mounted. Therefore, it is possible for each of the two suction nozzles on the mounting head to move in X and Y directions, to rotate around vertical axis, and to move upwards and downwards. Also, by mounting one θ axis motor that makes mounting head rotate around vertical axis and one vertical axis motor that moves mounting head upwards and downwards, it is possible to move only the selected suction nozzles upwards and downwards.

Reference numerical 16 is a recognition camera for recognizing component position. Each of said mounting heads 7 has two cameras, and there are four cameras in total. The camera performs the imaging of an electronic component for recognizing the amount of positioning error of the electronic component relative to the suction nozzle in X and Y direction, and rotation angle. Each camera can perform imaging of two electronic components simultaneously. Reference numerical 17 is a stocker for stocking nozzles. Although the stocker can store ten nozzles, it stores nine nozzles in this embodiment.

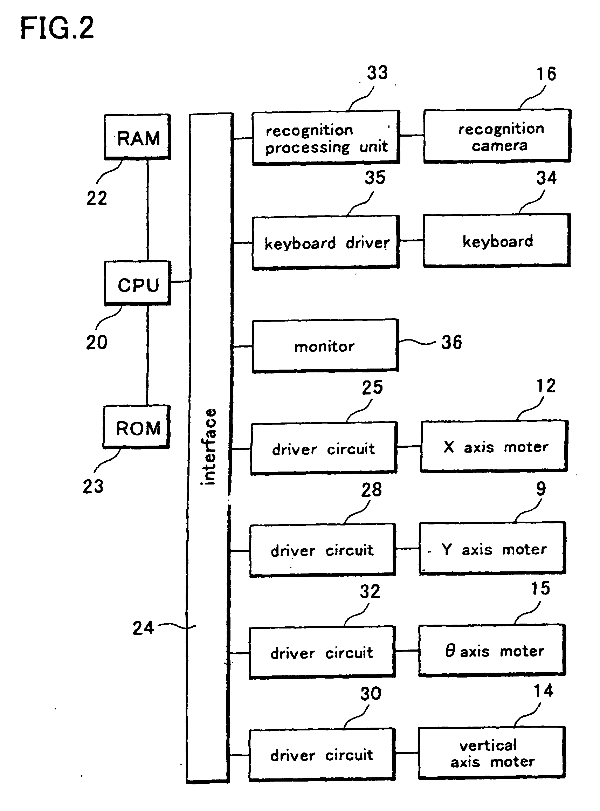

Fig. 2 is a block diagram for controlling the electronic component mounting apparatus. Each one of X axis motors 12, Y axis motors 9, θ axis motors 15 and vertical axis motors 14 are shown in the figure as a matter of convenience.

Reference numerical 20 is a CPU (mounting controlling unit) as a controlling unit that controls the mounting apparatus 1. To said CPU 20, RAM (random access memory) 22 and ROM (read only memory) 23 are connected through bus-line. CPU 20 controls the movements related to the component mounting procedure of electronic component mounting apparatus 1 based on the data stored in a rewritable manner in said RAM 22 and in accordance with the program stored in said ROM 23. Said RAM 22 can be a separate component or integrated as a set of registers into the CPU 20.

That is, CPU 20 controls the movements of said X axis motor 12 through interface 24 and driver circuit 25, the movements of said Y axis motor 9 through interface 24 and driver circuit 28, the movements of said θ axis motor 15 through interface 24 and driver circuit 32, and the movements of said vertical axis motor 14 through interface 24 and driver circuit 30.

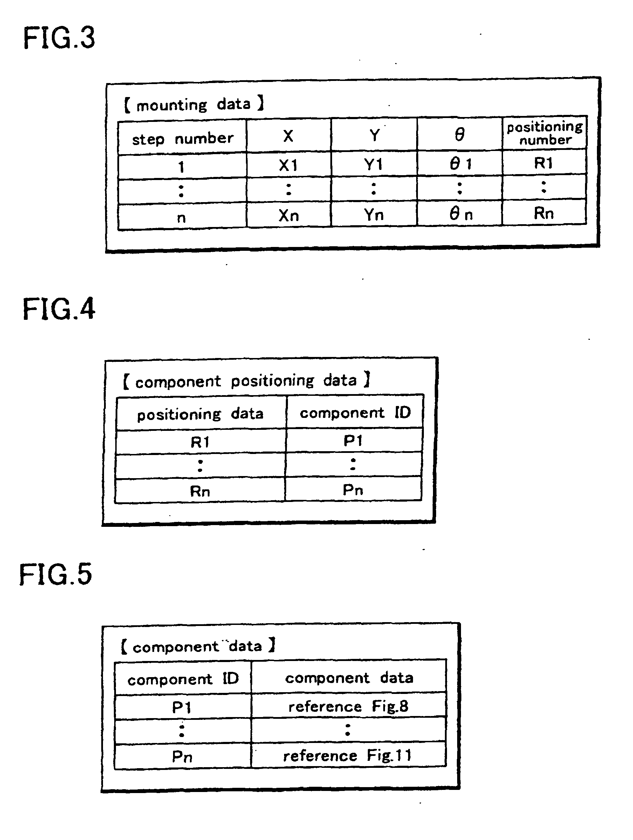

Mounting data related to component mounting as shown in Fig. 3 are stored in said RAM 22. For each step of the mounting (at each step number), the information on X direction (indicated by X), Y direction (indicated by Y) and angle (indicated by θ) in a print board and the information on positioning number of each component feeding unit 3 are stored. In said RAM 22, the component positioning data, as shown in Fig. 4, are stored. Here, the type of each component (component ID) corresponding to the positioning number of said component feeding unit 3 are stored. Also, in said RAM 22, the component data (parts library data) for component recognition that identify characteristics of each component, as shown in Fig. 5, are stored. This will be explained in detail later.

Reference numerical 33 is a recognition processing unit connected to said CPU 20 through interface 24 and the recognition processing of the images taken by said recognition camera 16 is performed based on said parts library data at said recognition processing unit 33, and then the result of the processing is sent to CPU 20. That is, CPU 20 outputs the direction to the recognition processing unit 33 to perform recognition processing (to calculate the amount of adjustment) on the image taken by the recognition camera 16, and receives the result of the recognition processing from the recognition processing unit 33.

Reference numerical 34 is a keyboard as a data registering means connected to said CPU 20 through keyboard driver 35 and interface 24, and reference numerical 36 is a monitor that displays the images of components. Said keyboard 34 is for inputting the characteristics of electronic components based on format screen. Also, in said RAM 22, a plurality of format for constructing parts library data is stored. As said data registering means, other means such as touch panel can be used in place of the keyboard 34.

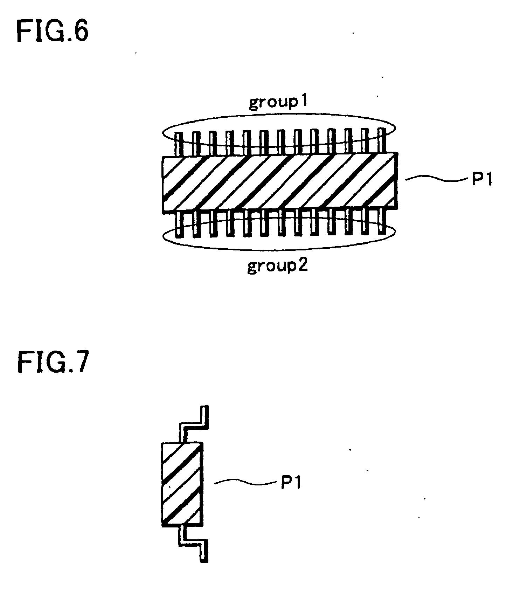

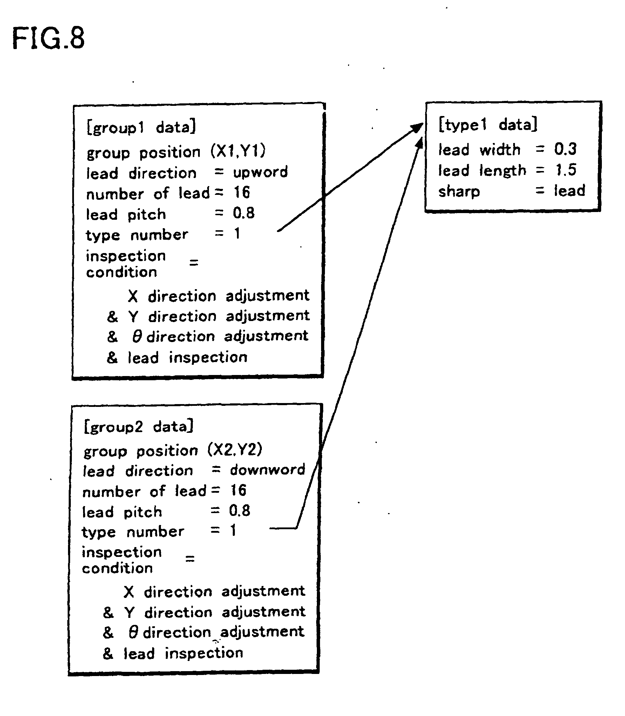

Next, the operation for registering component data used as component recognition data by using the electronic component mounting apparatus 1 as a data constructing apparatus of electronic component is explained. The electronic component with component ID of P1 has such a shape as shown in Figs. 6 and 7, and has a flat bottom. As to this component, the positions where the recognition processing by said recognition processing unit 33 is performed are classified into two groups. Group 1 data of the component data shown in Fig. 8 comprises X coordinate from the central position of the electrical component itself to the central position of group 1 in X direction, Y coordinate from the central position of the electronic component to the position of the tip of group 1 in Y direction, lead direction (upwards), the number of leads (16), lead pitch (0.8), and inspection condition, and is inputted by using the keyboard 34 and monitor 36, and stored in RAM 22. Group 2 data is also constructed in the same manner. Each of the type number 1 represents type 1 data where lead width (0.3), lead length (1.5) and shape (lead) are inputted in said manner, and stored in RAM 22.

Then, the inspection condition of each group, that is, the information regarding the use of the recognition result of each group is rewritably stored in RAM 22. As to the electronic component, this use of the result of the recognition processing is used for calculating the amount of adjustment in X, Y, and θ directions and for lead inspection (for inspecting positioning error and bending of the lead).

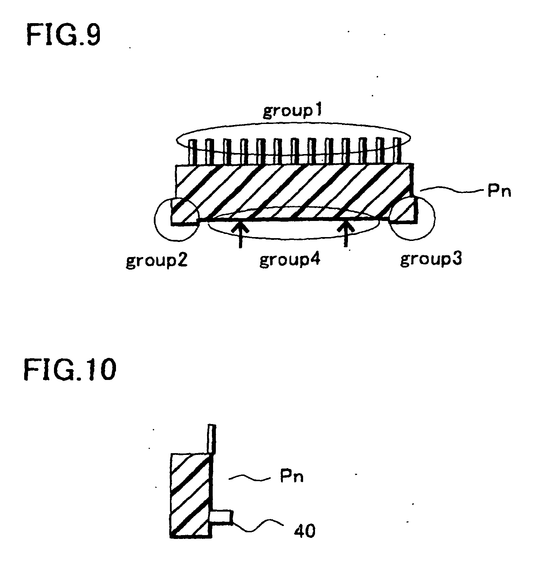

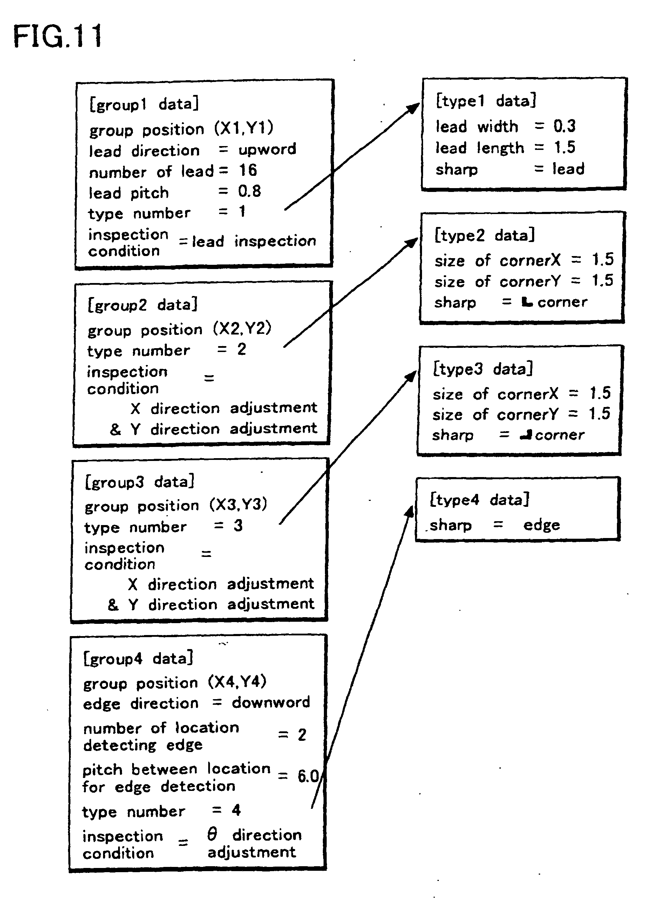

The electronic component with component ID of Pn, such as a connector, has the shape shown in Figs. 9 and 10, and has, for example, two pins and extrusions 40 to be inserted to a print board P on the bottom of the molding. As to this component, the locations for the recognition processing by said recognition processing unit 33 are classified into four groups that are described by circles and ovals in Fig. 9. Group 1 data of the component data shown in Fig. 11 comprises X coordinate from the central position of the electrical component itself to the central position of group 1 in X direction, Y coordinate from the central position of the electronic component to the position of the tip of group 1 in Y direction, lead direction (upwards), number of leads (16), lead pitch (0.8), and inspection condition, and is inputted by using the keyboard 34 and monitor 36, and stored in RAM 22. Group 2 data, group 3 data, and group 4 data are also constructed in the same manner. The group 4 comprises X coordinate from the central position of the electronic component itself (the molding) to the edge of the molding, which is the location for inspection (indicated by an arrow in Fig. 9) in X direction, Y coordinate from the central position of the electronic component itself to the edge of the molding, which is the locations for inspection in Y direction, the direction of the edge (downwards, that is, from black molding to white background in an image), the number of the locations on the edge for inspection (two), the pitch between the locations on the edge for inspection (0.6), and inspection condition, and is inputted by using keyboard 34 and monitor 36 and stored in RAM 22. Type number 1 represents type 1 data comprising lead width (0.3), lead length (1.5) and shape (lead), type number 2 represents type 2 data comprising the size of corner X (1.5), the size of corner Y (1.5) and shape, type number 3 represents type 3 data comprising the size of corner X (1.5), the size of corner Y (1.5) and shape, and type number 4 represents type 4 data comprising shape (edge). All these information are stored in RAM 22.

As to the electric component, the group 1 data is used for lead inspection (for inspecting positioning error and bending of the lead), the group 2 and the group 3 data are used for calculating the amounts of adjustment in X and Y directions, and the group 4 data is used for calculating the amount of adjustment in θ direction.

Next, manufacturing operation of the electronic component mounting apparatus is explained.

The mounting head 7 takes the electronic component P1 from the component feeding unit 3 and then carries it to the recognition camera 16. Next, said recognition camera 16 performs imaging of said electronic component P1, and the recognition processing unit 33 performs the recognition processing based on the images taken for detecting the positioning error of the electronic component P1 relative to the suction nozzle. The recognition processing operation is explained in detail hereinafter.

Based on the group 1 data, the group 2 data, and the component data of type 1 data stored in RAM 22 on the images taken, group position, lead direction, number of the lead, lead pitch, lead length are recognized by the recognition processing unit 33.

The result of the recognition is used for calculating the amounts of adjustment in X, Y, and θ and also used for lead inspection (for inspecting positioning error and bending of the lead). Based on the recognition result of the recognition processing unit 33, CPU 20 moves the beam 8 by the drive of Y axis motor 9 and the mounting head by the drive of X axis motor 12, and rotates the mounting head by the drive of θ axis motor by the amount of positioning error for making the adjustment of the nozzle position in X and Y directions and in rotating angle around vertical axis. After the adjustment, the vertical axis motor 14 starts driving to move said suction nozzle downwards and the electronic component is mounted on the right position in a print board.

When the recognition processing unit 33 recognizes an error (electronic component should not be mounted), the information is sent to CPU 20 and the electric component is discarded. The error is recognized, for example, when bending of the lead is beyond a tolerance, then the discarding processing is performed.

Said recognition camera 16 performs the imaging of said electronic component Pn, and the recognition processing of the electronic component Pn is performed by the recognition processing unit 33. The recognition processing is explained next. Based on the group 1 data and the component data of type 1 data stored in RAM 22 for the images taken, group position, lead direction, number of the lead, lead pitch, lead length are processed by the recognition processing unit 33. In the same manner, based on the component data of the group 2 data, the group 3 data, the type 2 data, and the type 3 data, group position, sizes of corners X and Y and shape are processed, and based on the component data of the group 4 data and the type 4 data, group position, edge direction, the number of the locations detecting edges, the pitch between the locations for edge detection, and shape are processed respectively.

The group 1 data is used for lead inspection (for inspecting positioning error and bending of the lead), the group 2 data and the group 3 data are used for calculating the amounts of adjustment in X and Y directions, and the group 4 data is used for calculating the amount of adjustment in θ direction. Then, the mounting processing or the discarding processing is performed as described above. In this embodiment, since the group 4 data is used for calculating the amount of adjustment in θ direction, it is possible to mount accurately components with pins and extrusions extruded from the molding, such as connectors, such that the pins and extrusions are accurately engaged with the holes formed in a print board.

Also, the locations of the recognition processing of said recognition processing unit 33 are classified into groups and the use of the recognition result of each group is rewritably stored in RAM 22. And CPU 20 realizes the use of the result of recognition processing by said recognition processing unit 33 based on the contents stored in said RAM 22. The result of the recognition of lead edge can also be used for calculating the amount of adjustment in θ direction.

As explained above, the electronic component mounting apparatus of the present invention can accurately mount electric component on a print board. In prior arts, since the position of the component with lead such as connector is determined based only on the position recognition of the tip of lead, an accurate angle relative to molding could not be obtained due to the poor accuracy of the electronic component itself, and thus the pins and extrusion extruded from the molding are not accurately engaged with the holes formed in a print board. The present invention, when applied to the component with lead such as connector, can mount accurately components with pins and extrusions extruded from the molding, such that the pins and extrusions are accurately engaged with the holes formed in a print board.

## Claims

1. An electronic component mounting apparatus comprising:
a recognition camera (16) for imaging an electronic component;
a memory (22) which stores data, depending on the characteristics of the different electronic components to be mounted, of at least two groups of locations which are to be imaged on said electronic component, the data of each group comprising component data and an information regarding use, the use comprising calculating an amount of adjustment in X, Y and θ direction and lead inspection;
a recognition processing unit (33) for performing recognition processing based on the images; and
a control unit (20);
the recognition processing unit (33) being configured to perform for the at least two groups a recognition processing based on images taken by the recognition camera (16) and on the data stored in the memory for said groups, and the control unit (20) being configured to calculate the amount of adjustment based on the result of the recognition processing and the information regarding the use stored in the memory (22) for said groups.

2. The electronic component mounting apparatus of claim 1
wherein the recognition processing is performed on a location for lead detection and a location for molding detection when an electronic component comprising a molding and leads is detected.

3. The electronic component mounting apparatus according to claim 1 or 2,
wherein the recognition processing is separately performed on a location for lead detection, a location for X and Y direction recognition, and a location for θ direction recognition when an electronic component with leads are recognized.

4. The electronic component mounting apparatus according to any of claims 1 to 3,
wherein the memory (22) stores the information regarding the use rewritably.

5. The electronic component mounting apparatus according to any of claims 1 to 4,
wherein the control unit (20) is designed to calculate amounts of adjustment for linear and/or angular positioning errors.

6. Method for mounting an electronic component on a print board comprising the steps:
imaging the electronic component,
retrieving data from a memory (22) which stores data, depending on the characteristics of the different electronic component to be mounted, of at least two groups of locations which are to be imaged on said electronic component, the data of each group comprising component data and an information regarding use, the use comprising calculating an amount of adjustment in X, Y and θ direction and lead inspection;
performing a recognition processing for the at least two groups based on images taken by the recognition camera (16) and on the data stored in the memory for said groups and further calculating the amount of adjustment based on the result of the recognition processing and the information regarding the use stored in the memory (22) for said groups.

7. Method according to claim 6
**characterized by**
rewritably storing the result of the recognition processing in the memory and by basing the information regarding the use of the results on data stored in the memory.

8. Method according to claim 6 or 7,
wherein the recognition processing is performed on a location for lead detection and a location for molding detection when an electronic component comprising a molding and leads is detected.

9. Method according to any of claims 6 to 8,
wherein placing the electronic component comprises mounting of the electronic component on the print board or discarding of the electronic component.

## Patentansprüche

1. Vorrichtung zum Montieren elektronischer Bauteile, die Folgendes aufweist:
eine Erkennungskamera (16) zur Bilddarstellung eines elektronischen Bauteils,
einen Speicher (22), der in Abhängigkeit von den Merkmalen der zu montierenden verschiedenen elektronischen Bauteile Daten von wenigstens zwei Gruppen von Positionen, die auf dem elektronischen Bauteil abzubilden sind, speichert, wobei die Daten jeder Gruppe Bauteildaten und eine Nutzungsinformation umfassen, wobei die Nutzung das Berechnen eines Betrages der Justierung in der X-, der Y- und der θ-Richtung und eine Anschlussleitungsinspektion umfasst,
eine Erkennungsverarbeitungseinheit (33) zum Durchführen einer Erkennungsverarbeitung anhand der Bilder; und
eine Steuerungseinheit (20);
wobei die Erkennungsverarbeitungseinheit (33) dafür konfiguriert ist, für die wenigstens zwei Gruppen eine Erkennungsverarbeitung anhand von Bildern, die von der Erkennungskamera (16) aufgenommen wurden, und anhand der Daten, die in dem Speicher für die Gruppen gespeichert sind, auszuführen, und wobei die Steuerungseinheit (20) dafür konfiguriert ist, anhand des Ergebnisses der Erkennungsverarbeitung und der Nutzungsinformationen, die in dem Speicher (22) für die Gruppen gespeichert sind, den Betrag der Justierung zu berechnen.

2. Vorrichtung zum Montieren elektronischer Bauteile nach Anspruch 1,
wobei die Erkennungsverarbeitung an einer Position zur Anschlussleitungserkennung und einer Position zur Formteilerkennung ausgeführt wird, wenn ein elektronisches Bauteil, das ein Formteil und Anschlussleitungen umfasst, erkannt wird.

3. Vorrichtung zum Montieren elektronischer Bauteile nach Anspruch 1 oder 2,
wobei die Erkennungsverarbeitung separat an einer Position zur Anschlussleitungserkennung, einer Position zum Erkennen der X- und der Y-Richtung und einer Position zur Erkennung der θ-Richtung ausgeführt wird, wenn ein elektronisches Bauteil mit Anschlussleitungen erkannt wird.

4. Vorrichtung zum Montieren elektronischer Bauteile nach einem der Ansprüche 1 bis 3,
wobei der Speicher (22) die Nutzungsinformationen überschreibbar speichert.

5. Vorrichtung zum Montieren elektronischer Bauteile nach einem der Ansprüche 1 bis 4,
wobei die Steuerungseinheit (20) dafür vorgesehen ist, Beträge für das Justieren linearer und/oder winkliger Positionierungsfehler zu berechnen.

6. Verfahren zum Montieren eines elektronischen Bauteils auf einer Leiterplatte, mit folgenden Schritten:
Abbilden des elektronischen Bauteils,
Abrufen von Daten aus einem Speicher (22), der in Abhängigkeit von den Merkmalen der zu montierenden verschiedenen elektronischen Bauteile Daten von wenigstens zwei Gruppen von Positionen, die auf dem elektronischen Bauteil abzubilden sind, speichert, wobei die Daten jeder Gruppe Bauteildaten und eine Nutzungsinformation umfassen, wobei die Nutzung das Berechnen eines Betrages der Justierung in der X-, der Y- und der θ-Richtung und eine Anschlussleitungsinspektion umfasst,
Durchführen einer Erkennungsverarbeitung für die wenigstens zwei Gruppen anhand von Bildern, die von der Erkennungskamera (16) aufgenommen wurden, und anhand der Daten, die in dem Speicher für die Gruppen gespeichert sind, und des Weiteren Berechnen des Betrages der Justierung anhand des Ergebnisses der Erkennungsverarbeitung und der Nutzungsinformationen, die in dem Speicher (22) für die Gruppen gespeichert sind.

7. Verfahren nach Anspruch 6,
**gekennzeichnet durch**
überschreibbares Speichern des Ergebnisses der Erkennungsverarbeitung in dem Speicher und **durch** Stützen der Nutzungsinformationen der Ergebnisse auf Daten, die in dem Speicher gespeichert sind.

8. Verfahren nach Anspruch 6 oder 7,
wobei die Erkennungsverarbeitung an einer Position zur Anschlussleitungserkennung und einer Position zur Formteilerkennung ausgeführt wird, wenn ein elektronisches Bauteil, das ein Formteil und Anschlussleitungen umfasst, erkannt wird.

9. Verfahren nach einem der Ansprüche 6 bis 8,
wobei das Anordnen des elektronischen Bauteils das Montieren des elektronischen Bauteils auf der Leiterplatte oder das Entsorgen des elektronischen Bauteils umfasst.

## Revendications

1. Appareil de montage de composant électronique comprenant :
une caméra de reconnaissance (16) pour créer une image d'un composant électronique ;
une mémoire (22) qui stocke des données, en fonction des caractéristiques des différents composants électroniques devant être montés, d'au moins deux groupes d'emplacements dont on doit faire une image sur ledit composant électronique, les données de chaque groupe comprenant des données sur le composant et des informations concernant l'utilisation, l'utilisation comprenant le calcul d'une quantité de réglage dans la direction X, Y et θ et l'inspection de connexions ;
une unité de traitement de reconnaissance (33) pour effectuer un traitement de reconnaissance en se basant sur les images ; et
une unité de commande (20) ;
l'unité de traitement de reconnaissance (33) étant configurée pour effectuer pour les au moins deux groupes un traitement de reconnaissance en se basant sur les images prises par la caméra de reconnaissance (16) et sur les données stockées dans la mémoire pour lesdits groupes, et l'unité de commande (20) étant configurée pour calculer la quantité de réglage en se basant sur le résultat du traitement de reconnaissance et sur les informations concernant l'utilisation stockées dans la mémoire (22) pour lesdits groupes.

2. Appareil de montage de composant électronique selon la revendication 1,
dans lequel le traitement de reconnaissance est effectué sur un emplacement pour la détection de connexions et un emplacement pour la détection de moulage lorsqu'un composant électronique comprenant un moulage et des connexions est détecté.

3. Appareil de moulage de composant électronique selon la revendication 1 ou 2,
dans lequel le traitement de reconnaissance est effectué séparément sur un emplacement pour la détection de connexions, un emplacement pour la reconnaissance des directions X et Y, et un emplacement pour la reconnaissance de la direction θ lorsqu'un composant électronique avec des connexions est reconnu.

4. Appareil de montage de composant électronique selon l'une quelconque des revendications 1 à 3,
dans lequel la mémoire (22) stocke les informations concernant l'utilisation de façon réinscriptible.

5. Appareil de montage de composant électronique selon l'une quelconque des revendications 1 à 4,
dans lequel l'unité de commande (20) est conçue pour calculer des quantités de réglage pour des erreurs de positionnement linéaires et/ou angulaires.

6. Procédé de montage d'un composant électronique sur une carte de circuit imprimé comprenant les étapes consistant à :
imager le composant électronique,
récupérer des données d'une mémoire (22) qui stocke des données, en fonction des caractéristiques des différents composants électroniques devant être montés, d'au moins deux groupes d'emplacement dont on doit faire une image sur ledit composant électronique, les données de chaque groupe comprenant des données sur le composant et des informations concernant l'utilisation, l'utilisation comprenant le calcul d'une quantité de réglage dans la direction X, Y et θ et l'inspection de connexions ;
effectuer un traitement de reconnaissance pour les au moins deux groupes en se basant sur les images prises par la caméra de reconnaissance (16) et sur les données stockées dans la mémoire pour lesdits groupes et calculer en outre la quantité de réglage en se basant sur le résultat du traitement de reconnaissance et les informations concernant l'utilisation stockées dans la mémoire (22) pour lesdits groupes.

7. Procédé selon la revendication 6,
**caractérisé en ce qu'**il stocke de façon rénscriptible le résultat du traitement de reconnaissance dans la mémoire et **en ce qu'**il base les informations concernant l'utilisation des résultats sur les données stockées dans la mémoire.

8. Procédé selon la revendication 6 ou 7,
dans lequel le traitement de reconnaissance est effectué sur un emplacement pour la détection de connexions et un emplacement pour la détection de moulage lorsqu'un composant électronique comprenant un moulage et des connexions est détecté.

9. Procédé selon l'une quelconque des revendications 6 à 8,
dans lequel le placement du composant électronique comprend le montage du composant électronique sur la carte de circuit imprimé ou la mise au rebut du composant électronique.
